Europäisches Patentamt

European Patent Office

Office européen des brevets

(11) Publication number: **0 090 638**
**B1**

# EUROPEAN PATENT SPECIFICATION

(45) Date of publication of patent specification: **16.01.91**

(51) Int. Cl.⁵: **G 06 F 11/00**

(21) Application number: **83301749.4**

(22) Date of filing: **29.03.83**

(54) **Cache memory systems.**

(30) Priority: **31.03.82 US 364052**

(43) Date of publication of application:
**05.10.83 Bulletin 83/40**

(45) Publication of the grant of the patent:
**16.01.91 Bulletin 91/03**

(84) Designated Contracting States:
**BE CH DE FR GB IT LI NL SE**

(56) References cited:
**EP-A-0 009 412**
**US-A-4 084 236**
**US-A-4 195 343**

**IBM TECHNICAL DISCLOSURE BULLETIN, vol. 13, no. 2, July 1970, pages 400-402, New York, US; M.W. BEE et al.: "Removal of failing buffer sections in a buffer-backing store"**

**IBM TECHNICAL DISCLOSURE BULLETIN, vol. 17, no. 7, December 1974, pages 2038-2039, New York, US; T.P. AHEARN et al.: "Automatic partial deletion of high-speed buffer entries"**

(73) Proprietor: **Bull HN Information Systems Inc. Corporation Trust Center 1209 Orange Street Wilmington County of New Castle Delaware (US)**

(72) Inventor: **Keeley, James W.**
**4 Watersedge Drive**
**Hudson New Hampshire 03051 (US)**
Inventor: **Fisher, Edwin P.**
**652 Adams Street**
**N. Abington Massachusetts 02351 (US)**
Inventor: **Curley, John L.**
**23 Willow Ridge Road**
**North Andover Massachusetts 01845 (US)**

(74) Representative: **Geissler, Bernhard, Dr. Patent- und Rechtsanwälte et al Bardehle-Pagenberg-Dost- Altenburg- Frohwitter & Partner Postfach 86 06 20 D-8000 München 86 (DE)**

## Description

The present invention relates to cache memory systems, and more specifically to error management within such systems.

The use of cache memory systems in computers is well known; the cache memory is a small high-speed memory which is arranged to contain recently used words, duplicating those words in main memory, and thereby allowing more rapid access to those words if they should be required again.

The problem of the reliability of such cache memories has received attention. Simple parity detection can be used, with parity errors being used simply to invalidate a word with bad parity from the cache (so that the word has to be accessed in main memory). More advanced systems are also known in which reliable operation is achieved by invalidating cache memory locations detected as having bad parity. This requires additional bits to be associated with the cache locations, and can add considerably to the cost and complexity of the cache memory. More importantly, it requires processing time for carrying out such invalidating operations.

Such a cache memory is shown in the article of Bee, in IBM Technical Disclosure Bulletin, July 1970, pages 400 to 402. In this article addresses stored in the directory are protected by parity bits. Upon the detection of a parity error, an OK bit in the respective entry is turned off and by means of a machine check trap routine the respective section is removed from the replacement algorithm.

Other known cache systems permit the cache to be bypassed on the detection of fault conditions by the central processing unit (CPU) associated therewith. This type of cache system may be designed to report two types of errors to the CPU, a memory "red" error condition indicative of an uncorrectable error and a memory "yellow" condition indicative of a correctable error. Upon the receipt of a "red" error signal or the detection of a byte data parity error in received memory data, the CPU switches the entire cache offline, reports the error to the operating system, and continues processing. While this system allows disconnection of a cache unit as a consequence of a fault condition, it requires the CPU to process such fault conditions. This can prove time consuming and could also result in loss of valuable information, since such diagnosis relies in part upon the type of error conditions reported by the cache system itself. Also, a "red" error causes a total loss of the entire cache memory.

In another known cache system (US—A—4 084 236) the cache directory is protected by means of parity bits. When an error is detected a condition is simulated, that the requested information was not in the cache and is fetched, instead, from the backing store.

The article of AHEARN et al. in IBM Technical Disclosure Bulletin, December 1974, pages 2038-2039 mentions row delete batches to disable corresponding address arrays, row compare logics, date arrays and to influence the replacement algorithm to inhibit the same. But no circuit details are given.

Accordingly, the main object of the present invention is to provide a reliable cache system which has low cost and complexity.

It is another object of the present invention to provide a cache system which allows automatic and fast partial disabling of the system.

These objects are achieved by a cache memory as claimed in claim 1.

A cache memory embodying the invention will now be described, by way of example, with reference to the drawings, in which:

Figure 1 is a block diagram of the cache memory;

Figure 2 is a block diagram of the round robin replacement unit;

Figures 3 and 4 are a block diagram of the mode control unit; and

Figure 5 is a block diagram of the write control unit.

Introductory Summary

The present system is concerned with a multilevel associative cache system, including directory and cache stores organized into a number of levels of memory locations.

The directory store includes error detection apparatus for detecting errors in the directory store addresses during cache read and write memory cycles of operation. The error detection apparatus is coupled to control apparatus which combines the error signals with signals indicative of cache hits to produce invalid hit detection signals. The presence of soft or hard errors within the directory store indicated by invalid hit signals, if undetected, would result in the cache system delivering false or incorrect data.

The control apparatus is coupled to round robin replacement apparatus which is used to identify the cache level in which information is to be replaced. The control apparatus, in response to the occurrence of a first invalid hit detection signal, places the cache system in a degraded mode. When in this mode, the replacement apparatus as well as other portions of the cache system are conditioned to limit cache read and write memory operations to a subdivision of the number of cache levels which are error free, thereby gracefully degrading cache operation. In order to preserve the integrity of memory information, the control apparatus, in response to the occurrence of subsequent invalid hit detection signals, generates signals which effectively place the cache system off-line.

The above arrangement improves system reliability and performance. By including apparatus within the cache which can disable subdivisions of the cache system associated with directory errors, the processing time normally required to verify reported failures and carry out disabling operations is eliminated. Since the cache system is still operational, CPU performance is not substantially reduced as in those system which by-pass the entire cache system in response to a memory failure.

Additional increases in performance and speed result from disabling cache subdivisions only in response to error conditions detected during cache hits which reduces the number of necessary checks to a minimum. That is, checking is limited to situations which will result in the delivery of false data.

Detailed Description

The present cache memory is designed to operate in conjunction with a main memory of $2^{20}$ words, so that the memory address is 20 bits long. This address is divided, for use in the cache, into two halves, the top or most significant 10 bits MSA and the bottom or least significant 10 bits LSA. The cache can be regarded as comprising $2^{10}$ separate columns, each having 4 levels. When an address is supplied to the cache, the LSA half selects the column in the cache. The cache comprises a data store and a directory, each divided into the $2^{10}$ columns and 4 levels, together with various control and other circuitry. The selected column in the store contains 4 words, each with the LSA half of its address being that of that column. The corresponding column in the directory contains the MSA halves of the addresses of these 4 words — each level in the directory contains the MSA half of the address of the word in the corresponding level in the store. The main memory can be regarded as arranged as $2^{10}$ rows, each addressed by the MSA half of the main memory address, and $2^{10}$ columns, each addressed by the LSA half of the main memory address. Thus the MSA and LSA address halves can be regarded as row and column addresses respectively.

In operation, the LSA half of the desired address is used to select a column in the directory, and the 4 MSA address halves therein are read out and compared with the MSA address half of the desired address. If there is a match, the data in the corresponding level of the same column in the store is accessed. If there is no match, then the desired address is not in the cache, and an existing address must be displaced so that the desired address can be inserted. The algorithm used for this is a "round robin" one. Each column has associated with it a respective cyclic counter which points to the level into which the new word is to be placed. As a new word is placed in a level (thereby displacing the word which was previously in that level), the counter is incremented cyclically to point to the next level (in cyclic order), so that the next time a new word is to be placed in that column, it will go into the next level.

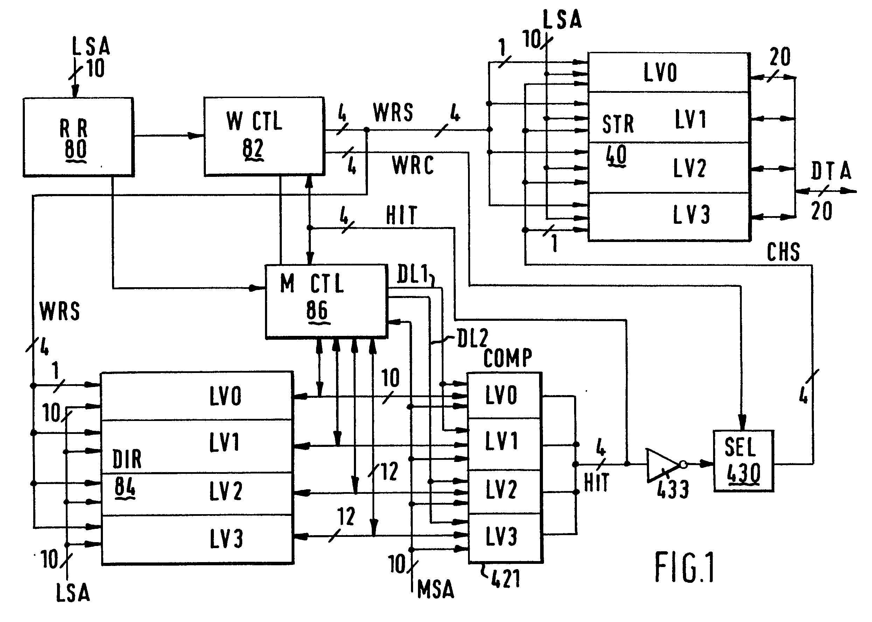

Referring now to Figure 1, the cache includes a store STR 40 which stores data words. This store is divided into 4 levels LV0 to LV3, and each level contains 1024 storage locations, each of which is 20 bits long. 20-bit data words are fed into the store, and read from it, over a 20 bit wide data bus DTA. Each of the 4 levels of the store is addressed by the 10-bit LSA portion of the main memory address of the data word. In addition, each of the 4 levels has an enable input, which has to be enabled for the level to be enabled. The enable inputs are respective bits from a 4-bit chip enable bus CHS. Also, each of the 4 levels has a write enable input; the state of this input determines whether the level is read from or written in. The write enable inputs are respective bits from a 4-bit write enable bus WRS.

A directory section DIR 84 stores the MSA address portions of the addresses of the words stored in the store 40. When an address is supplied to the cache, the LSA portion addresses four locations, one in each of the four levels LV0 to LV3, of the store 40, and this same LSA address portion addresses the corresponding four locations, one in each of the four levels LV0 to LV3 into which the directory 84 is divided, in the directory. The four stored MSA address portions (of the four words in the store 40) are thereby read out and fed to a comparator unit COMP 421, which is also divided into four levels LV0 to LV3. The four levels of the comparator 421 are also fed with the MSA portion of the address of the desired word. Each of the four levels of the comparator unit produces a "hit" signal if there is a match between the two MSA address portions fed to it, and the four outputs together form a 4-bit hit bus HIT. These hit signals are combined with write control signals on a 4-bit bus WRC in a selector unit 430, to produce the chip enable signals on bus CHS to the store 40. Hence, if the desired word is in the cache, one of the four hit signals will go true, and the corresponding level in the store 40 will be enabled, so that the desired word can be accessed for reading or writing.

The system as so far described is largely adequate for cache operation if the desired word is in the cache. It need be noted, additionally, only that the hit signals HIT are fed to a write control unit 82, so that the appropriate write enable signals may be generated if the desired word is to be written rather than read.

It may however happen that the desired word is not already resident in the cache. That will be indicated by all four of the outputs of the comparator unit 421 indicating a miss. If this happens, an existing word in the cache must be displaced and the new word written in. The selection of the level into which the new word is written is determined in accordance with a "round robin" algorithm, which selects the four levels 0, 1, 2, 3, 0, etc cyclically for successive new words. This is controlled by a round robin counter unit RR 80, which is coupled to the write control unit W CTL 82 which generates the write select signals WRS. It is also coupled to a mode control unit M CTL 86, which controls the writing of the MSA portion of the address of the new word in the directory 84.

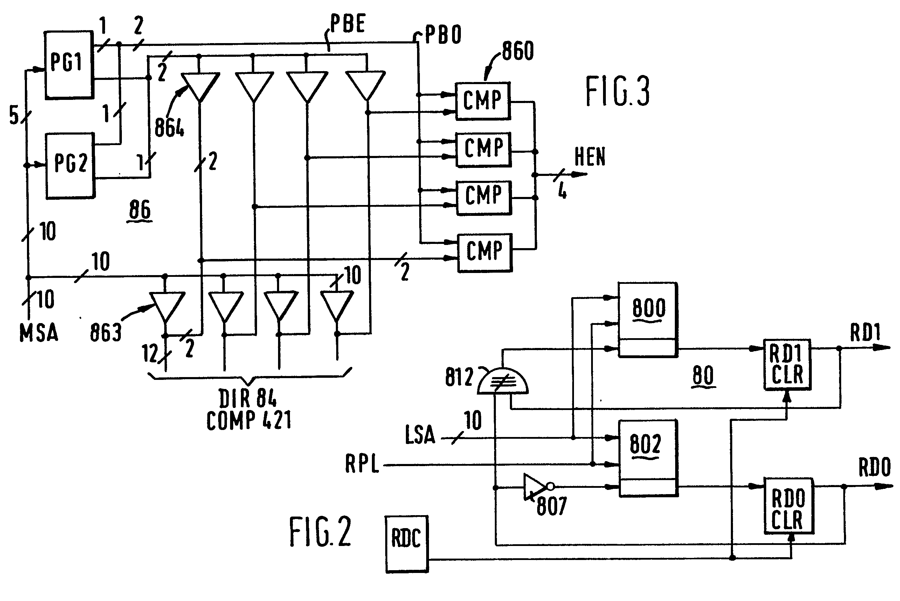

Figure 2 shows the round robin unit 80. There is a pair of $1024 \times 1$ bit storage units 800, 802, which are addressed by the LSA portion of the desired address; these together store a separate 2-bit number for each of the 1024 columns of the cache. The 2-bit number for the appropriate column is therefore read out, and is stored in a pair of flip-flops RD0, RD1. This number indicates the level in which the next word is to be written, and the two outputs RD0, RD1 are fed to the write control unit 82 for decoding to generate the 1-out-of-4 signal WRS, which is fed to the store 40 and the directory 84 to select the appropriate level for writing. If a fresh word is being written, the round robin count for that level must also be updated, i.e. cyclically incremented. This is done by means of an inverter 807, which changes the lower bit, and an Exclusive-OR gate 812, which changes the upper bit if the two bits are different. The outputs from the two gates 807 and 812 are written back into the two stores 800, 802. This only occurs on the writing of a new word into the cache; if the word with the desired address is already in the cache, the round robin unit 80 is inactive. A round robin clear flip-flop RDC is controlled, by suitable timing signals not shown, to clear the two flip-flops RD0 and RD1 appropriately and control them for such matters as initialization.

Figure 3 shows part of the mode control circuit 86. Since the four output address portions from the four levels of the directory 84 are different, and all four are fed individually to the comparator unit 421, the MSA address portion must be buffered separately to each level. This is done by the four sets of buffers 863. In addition, the MSA portion is divided into two 5-bit sections, which are fed to two respective parity generators PG1, PG2, each of which generates a parity bit and its complement. The two parity bits are combined on a 2-bit even parity bus PBE, and are buffered through four sets of buffers 864 to the four levels of the directory 84, so that the buses to the directory are 12 bits, 10 for the MSA portion plus 2 for parity.

The output from each level of the directory 84, when a desired address is being searched for in the cache, is thus a 12-bit signal, 10 bits MSA portion plus 2 bits parity. The 10-bit MSA portion is fed to the corresponding level of the comparator unit 421, for comparison with the MSA portion of the desired address. The 2 parity bits are fed back to the circuitry shown in Figure 3, and passed to a corresponding one of four parity comparators 860. The MSA portion of the desired address is fed to the parity generators PG1, PG2, to generate a 2-bit odd parity signal PB0, which is also fed to the four comparators 860 (each of which may comprise a pair of Exclusive-OR gates feeding a NOR gate). These generate a 4-bit hit enable signal HEN. The use of both even and odd parity bits, one for storage in the directory and the other for comparison with the stored bit, results in a simplification and saving in logic levels.

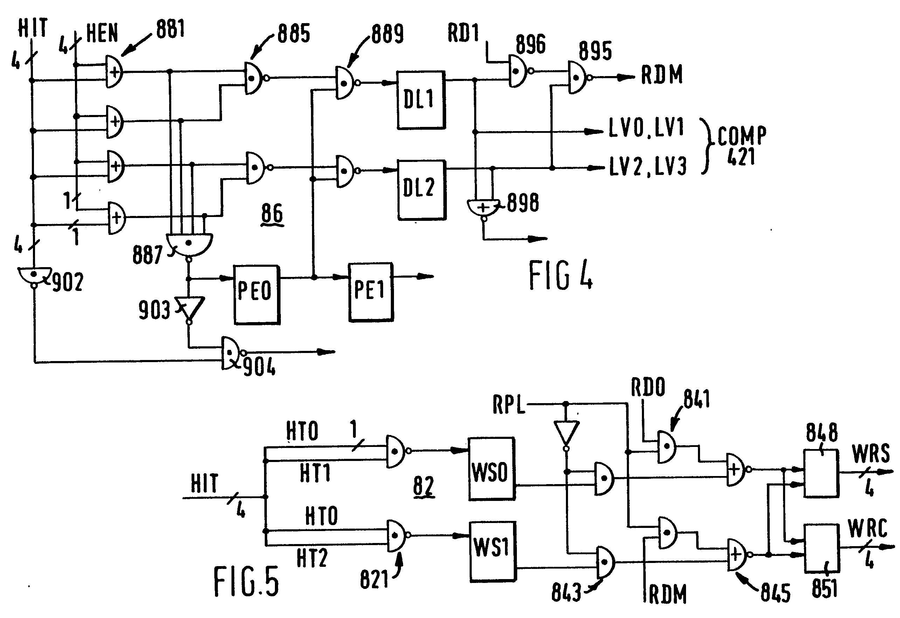

The hit enable signals HEN are combined with the hit signals HIT in a further portion of the mode control circuit 86, shown in Figure 4. The hit enable signals are the result of comparing parity bits generated from the desired MSA address portion with the parity bits of the stored MSA address portions, and obviously it is only in the event of a hit that this comparison is meaningful. Hence the hit enable signals HEN are combined with the corresponding hit signals HIT, by a set of four gates 881. Negative logic is in fact used at this point, so that the outputs of these gates will normally be 1. A hit will give one 0 input to one of these gates, and the hit enable signal for that gate should also be 0 (representing a match between the parity bits of the stored MSA address portion for that level and the desired MSA address portion, these being identical since there was a hit). The presence of all ones or otherwise of a 0 from one of the gates 881 is detected by a gate 887, which sets a first parity error flip-flop PE0 accordingly. This in turn sets a second parity error flip-flop PE1.

At the same time, the occurrence of a hit is detected by a gate 902, which is fed with all bits of the HIT bus. This gate feeds a gate 904, which is also fed from the gate 887 via an inverter 903. Hence the output of gate 904 indicates when there has been a valid hit — i.e. a hit which was not accompanied by a parity error. The output of this gate is used to determine whether or not a fresh word is to be written into the cache.

It will be realized that an error in the directory 84 may change either a bit of the MSA portion or a parity bit. In the latter event, the hit will actually be valid, but cannot be relied on since the parity is wrong. In the former case, a hit may occur which is truly invalid, since the theoretical true stored MSA portion does not match the desired MSA portion. In that case, the parity comparison will fail, since the stored parity bits will be those for the true stored MSA portion, not what the stored MSA portion has become as a result of the error, and will not match the parity bits for the desired MSA portion.

The outputs of the four gates 881 are combined by two gates 885, to determine whether the error occurred in the pair of levels 0 and 1, or in the pair of levels 2 and 3. These two gates feed two respective degrade level flip-flops DL1 and DL2 via a pair of gates 889, which are enabled by the setting of the first parity error flip-flop PE0. Thus a parity error in level 0 or 1 sets flip-flop DL1; a parity error in level 2 or 3 sets flip-flop DL2.

The cache, as will be seen, can still operate though in a degraded mode if either one of the flip-flops DL1 and DL2 is set. If both are set, however, the cache cannot operate at all. This state is detected and signalled to the CPU by a gate 898.

The setting of a degrade level flip-flop indicates that the corresponding pair of levels are not reliable, and must therefore no longer be used. Accordingly, the two signals DL1 and DL2 from these two flip-flops are fed to the four comparators of the comparator unit 421, as shown in Figure 1. Signal DL1 is fed to levels 0 and 1, so as to disable the comparisons for these two levels when flip-flop DL1 is set; similarly, signal DL2 is used to disable the comparisons for levels 2 and 3 when an error has occurred in either of these two levels.

Figure 5 shows the write control circuitry 82 in detail. This has to select the appropriate level for writing in two situations; writing after a hit, and writing a new word if there has been no hit.

If there has been a hit, the level in which the hit occurred is coded by means of a pair of write select flip-flops WS0 and WS1. As shown, these two flip-flops are fed from the HIT bus by means of two gates 821, which are fed with the level 0, 1, and 2 HIT signals HT0, HT1, and HT2 as shown. Thus flip-flop WS0 is set if there is a hit in levels 0 or 1, and flip-flop WS1 is set if there is a hit in levels 2 or 3. (The HIT bus uses negative logic.)

A signal RPL determines whether the write selection is for replacement (no hit) or simple rewriting of a word already in the cache (a hit). For rewriting, the complement of signal RPL enables a pair of gates 843 to pass the outputs of the two flip-flops WS0 and WS1. For replacement, signal RPL enables a pair of gates 841, which are fed with the signals RD0 and RDM, derived respectively from the two round robin flip-flops RD0 and RD1. The selected pair of signals pass through a further pair of gates 845 to a pair of decoders 848 and 851, which decode the 2-bit signals from gates 845 into the 1-out-of-4 signals of buses WRS and WRC. Two separate decoders are used because this allows separate enable control of the two buses WRS and WRC. It is necessary to be able to enable these two buses separately because bus WRC is used, via the selector unit 430, for reading as well as writing in the store 40.

Considering the selection of the round robin outputs for write control more closely, it is necessary to be able to select the four levels in sequence when the cache is fully operational, but to select only between levels 0 and 1, or only between levels 2 and 3, when one or other of flip-flops DL1 and DL2 is set and the cache is operating in the degraded mode. This is achieved by feeding the write control circuitry 82 with the round robin unit outputs after modification in the mode control unit 86 instead of directly. In fact, the output of flip-flop RD0 is fed to the write control unit 82 directly. However, the output of flip-flop RD1 is fed through two gates 896 and 895, Figure 4, in the mode control unit 86 to generate a signal RDM which is fed to the write control unit 82.

The flip-flop RD1 selects between the two lower levels 0 and 1 and the two upper levels 2 and 3, while the flip-flop RD0 selects between level 0 and level 1, or between level 2 and level 3. The two gates 896 and 895 determine signal RDM in dependence on signal RD1 such that if neither of the degrade level flip-flops DL1 and DL2 is set (normal operation), signal RDM is the same as RD1; if flip-flop DL1 is set, indicating an error in levels 0 and 1, signal RDM is forced to 1; while if flip-flop DL2 is set, indicating an error in levels 2 and 3, signal RDM is forced to 0. Thus the level for replacement will normally be selected in cyclic sequence, but if an error has occurred in levels 0 or 1, only levels 2 and 3 can be selected (cyclically) for replacement, while if an error has occurred in levels 2 and 3, only levels 0 and 1 can be selected (cyclically) for replacement. The level selection between the two available levels for replacement in the event of a failure in the other two levels is still determined for each column (LSA portion) independently by the round robin unit 80.

The general operation of the system can therefore be summarized as follows. Its initial and normal state is with all four levels in use and both degrade level flip-flops cleared. On detection of a parity error, it is convenient to check also whether a CPU read request is being performed, since if this is not so, there is a bus write cycle and the error can be disregarded as a write is occurring which will not be affected by the error. However, on a parity error for a CPU read request, one or other of the degrade level flip-flops will be set. The cache then continues to operate but in a degraded mode, with only two levels operative. This state is signalled to the CPU by the second parity error flip-flop. The performance of the whole system in which the cache is included will be slightly degraded, since the cache will hold only half as many words as usual and more main memory accesses than usual will be required. On the occurrence of a parity error in one of the remaining two levels (again for a CPU read request), the other degrade level flip-flop is set, and the cache becomes wholly inoperative.

It will be realized, of course, that the above description is in simplified terms, and in practice, various elaborations may be required. In particular, timing signals have been almost wholly omitted in this description. Also, of course, the details of the manner in which the required logical functions are performed may be varied substantially, in dependence on the techniques preferred by the designer, the logic system employed, the available components, etc.

**Claims**

1. A cache memory comprising:
a data store (STR 40) comprising a plurality of columns, each comprising a plurality of levels (LV0 to LV3) each of which stores a data word (DTA);
a directory store (DIR 84) correspondingly comprising a plurality of columns and levels, each level of each column storing the row address (MSA) of the corresponding word in the data store;
comparator means (421) for comparing a desired row address with the row addresses stored in the column of the directory store selected by a desired column address (LSA) and for generating HIT signals;
means (430, 82) for accessing the corresponding data word in the data store on a successful match;
replacement means (80, 82) for indicating a replacement cache location and for inserting into this location a word not already stored therein; and

error detection means (86, Fig. 3) for detecting parity errors in the row addresses read from the directory store and for partially disabling the cache memory upon the occurance of an error;

characterized by the replacement means (80) comprising Round Robin counting means and level latching means (RD0, RD1) for storing coded information designating for each column a next one of said levels into which replacement data is to be written;

by mode control means (86, Fig. 4) combining a hit enabling signal (HEN) generated by said error detection means (Fig. 3) with the HIT signal for generating a valid HIT signal in case of no error, and for setting degrade level latching means (DL1, DL2) in case of an error, said mode control means further comprising first logic means (896, 895) being controlled by said degrade level latching means for modifying part of the output signals (RD1) from said level latching means and for generating a level designating disabling signal (RDM); and

by write control means (82, Fig. 5) for receiving said HIT signals, for receiving a signal indicating a necessary replacement (RPL), for receiving another part of the output signals (RD0) from said level latching means and for receiving said level designating disabling signal, to generate level designating write and read control signals (WRS, WRC), whereby one or more levels (subdivisions) of the cache memory can be disabled.

2. A cache memory according to claim 1 wherein the write control means (Fig. 5) comprises a first decoder (848) coupled to said level designating disabling signal (RDM) and to said other part of output signals (RD0) from said level latching means for generating a write control signal (WRS) for selecting a level for replacement writing, and further comprises a second decoder (851) being also coupled to said RDM signal and to said RD0 signal for generating a read or write control signal (WRC) for selecting a level for reading or for rewriting a word already stored in the cache memory.

3. A cache memory according to claim 2 wherein said write control means (Fig. 5) comprises a plurality of write select latches (WS0, WS1) for receiving said HIT signals and for delivering coded level designating signals to level designating logic circuits (843, 841, 845) receiving said RPL signal, said RD0 signal and said RDM signal, and being connected to said decoders (848, 851).

4. A cache memory according to claim 1 wherein said replacement means (80) comprises a number of memories (800, 802) being addressed by said column address (LSA) and storing each for an associated latch (RD0, RD1) in said level latching means a coded level designating information.

5. A cache memory according to any previous claim wherein said mode control means is responsive to errors only on read operations.

6. A cache memory according to claim 1, comprising second logic means (887, PE0, PE1)

coupled to logic combination means (881) for combining said HIT signals with said HEN signals to indicate when the cache has at least one level inoperative.

7. A cache memory according to claim 6 wherein said mode control means (Fig. 4) comprises a plurality of degrade level flip-flops (DL1, DL2) each of which is associated with a respective level or plurality of levels and which, when set, renders inoperative the associated level or levels said degrade level flip-flops being set by said second logic means.

8. A cache memory according to claim 7 comprising logical AND means (898) coupled to said degrade level flip-flops (DL1, DL2) to indicate when the cache is wholly inoperative.

9. A cache memory according to claim 7 comprising two degrade level flip-flops (DL1, DL2) each designating one half of the levels of the cache memory, one of said flip-flops being set upon the occurance of a first error and the other being set upon the occurance of a second error, thereby removing the cache memory from operation.

## Patentansprüche

1. Cache-Speicher, der aufweist:

einen Datenspeicher (STR 40), der eine Vielzahl von Spalten aufweist, wobei jede eine Vielzahl von Pegeln (LV0 bis LV3) aufweist, von denen jeder ein Datenwort (DTA) speichert;

einen Verzeichnis-Speicher (DIR 84), der entsprechend eine Vielzahl von Spalten und Pegeln aufweist, wobei jeder Pegel jeder Spalte die Zeilenadresse (MSA) des entsprechenden Wortes in dem Datenspeicher speichert;

eine Komparatoreinrichtung (421) zum Vergleichen einer gewünschten Zeilenadresse mit den Zeilenadressen, die in der Spalte des Verzeichnis-Speichers gespeichert sind, der durch eine gewünschte Spaltenadresse (LSA) ausgewählt wird, und zum Erzeugen von HIT-Signalen;

eine Einrichtung (430, 82) zum Zugreifen auf das entsprechende Datenwort in dem Datenspeicher nach erfolgreicher Übereinstimmung;

eine Verschiebeeinrichtung (80, 82) zum Anzeigen einer Cache-Verschiebestelle und zum Einfügen eines nicht schon dort gespeicherten Wortes an dieser Stelle; und

eine Fehlererfassungseinrichtung (86, Fig. 3) zum Erfassen von Paritätsfehlern in den Zeilenadressen, die aus dem Verzeichnis-Speicher gelesen sind, und zum teilweisen Abschalten des Cache-Speichers nach dem Auftreten eines Fehlers;

dadurch gekennzeichnet, daß die Verschiebeeinrichtung (80) eine Round-Robin-Zähleinrichtung und eine Pegellatcheinrichtung (RD0, RD1) aufweist zum Speichern einer kodierten Information, die für jede Spalte einen nächsten der Pegel bestimmt, in die Verschiebedaten zu schreiben sind;

daß eine Modensteuereinrichtung (86, Fig. 4) ein durch die Fehlererfassungseinrichtung (Fig. 3) erzeugtes HIT-Befähigungssignal (HEN) mit dem HIT-Signal kombiniert, um im Falle von keinem Fehler ein gültiges HIT-Signal zu erzeugen, und um im Falle eines Fehlers eine Pegelverringerungslatcheinrichtung (DL1, DL2) einzustellen, wobei die Modensteuereinrichtung weiterhin eine erste Logikeinrichtung (896, 895) aufweist, die durch die Pegelverringerungslatcheinrichtung gesteuert wird zum Ändern eines Teils der Ausgangssignale (RD1) aus der Pegellatcheinrichtung und zum Erzeugen eines Pegelbestimmungsabschaltsignals (RDM); und

daß eine Schreibsteuereinrichtung (82, Fig. 5) die HIT-Signale empfängt, ein Signal empfängt, das eine nötige Verschiebung (RPL) anzeigt, einen anderen Teil der Ausgangssignale (RD0) aus der Pegellatcheinrichtung empfängt und das Pegelbestimmungsabschaltsignal empfängt, um Schreib- und Lesesteuersignale (WRS, WRC) zur Pegelbestimmung zu erzeugen, wodurch einer oder mehrere Pegel (Unterteilungen) des Cache-Speichers abgeschaltet werden können.

2. Cache-Speicher nach Anspruch 1, wobei die Schreibsteuereinrichtung (Fig. 5) einen ersten Dekodierer (848) aufweist, der mit dem Pegelbestimmungsabschaltsignal (RDM) und dem anderen Teil der Ausgangssignale (RD0) aus der Pegellatcheinrichtung gekoppelt ist, um ein Schreibsteuersignal (WRS) zum Auswählen eines Pegels für ein Verschiebungsschreiben zu erzeugen, und sie weist weiterhin einen zweiten Dekodierer (851) auf, der auch mit dem RDM-Signal und dem RD0-Signal gekoppelt ist, um ein Lese- oder Schreibsteuersignal (WRC) zum Auswählen eines Pegels zum Schreiben oder zum nochmaligen Schreiben eines schon in dem Cache-Speicher gespeicherten Wortes zu erzeugen.

3. Cache-Speicher nach Anspruch 2, wobei die Schreibsteuereinrichtung (Fig. 5) eine Vielzah von Schreibauswahllatches (WS0, WS1) aufweist zum Empfangen der HIT-Signale und zum Liefern kodierter Pegelbestimmungssignale zu Pegelbestimmungs-Logikschaltungen (843, 841, 845), die das RPL-Signal, das RD0-Signal und das RDM-Signal empfangen und die mit den Dekodierem (848, 851) verbunden sind.

4. Cache-Speicher nach Anspruch 1, wobei die Verschiebeeinrichtung (80) eine Anzahl von Speichen (800, 802) aufweist, die durch die Spaltenadresse (LSA) adressiert sind und je für einen zugehörigen Latch (RD0, RD1) in der Pegellatcheinrichtung eine kodierte Pegelbestimmungsinformation speichem.

5. Cache-Speicher nach einem der vorangehenden Ansprüche, wobei die Modensteuereinrichtung nur auf Fehler nach Leseoperationen antwortet.

6. Cache-Speicher nach Anspruch 1, der eine zweite Logikeinrichtung (887, PE0, PE1) aufweist, die mit einer Logikkombinationseinrichtung (881) zum Kombinieren der HIT-Signale mit den HEN-Signalen gekoppelt ist, um anzuzeigen, wenn der Cache mindestens einen nicht arbeitenden Pegel aufweist.

7. Cache-Speicher nach Anspruch 6, wobei die Modensteuereinrichtung (Fig. 4) eine Vielzahl von Pegelverringerungs-Flipflops (DL1, DL2) aufweist, von denen jedes einem jeweiligien Pegel oder einer Vielzahl von Pegeln zugeordnet ist, und das, wenn es eingestellt ist, unbetätigt den zugehörigen Pegel oder die Pegel an die Pegelverringerungs-Flipflops abgibt, die durch die zweite Logikeinrichtung eingestellt sind.

8. Cache-Speicher nach Anspruch 7, der eine logische AND-Einrichtung (898) aufweist, die mit den Pegelverringerungs-Flipflops (DL1, DL2) gekoppelt ist, um anzuzeigen, wenn der Cache völlig unbetätigt ist.

9. Cache-Speicher nach Anspruch 7, der zwei Pegelverringerungs-Flipflops (DL1, DL2) aufweist, von denen jedes eine Hälfte der Pegel des Cache-Speichers bestimmt, wobei eines der Flipflops nach dem Auftreten eines ersten Fehlers eingestellt wird und das andere nach dem Auftreten eines zweiten Fehlers eingestellt wird, wodurch der Cache-Speicher außer Betrieb gesetzt wird.

**Revendications**

1. Une mémoire antémémoire comprenant:

une mémoire de données (STR 40) comprenant une pluralité de colonnes, dont chacune comprend une pluralité de niveaux (LV0 à LV3), dont chacun enregistre un mot de donnée (DTA);

une mémoire de répertoire (DIR 84) comprenant, en correspondance, une pluralité de colonnes et de niveaux, chacun des niveaux de chaque colonne enregistrant l'adresse de rang (MSA) du mot correspondant dans la mémoire de données;

des moyens de comparaison (421) pour comparer une adresse de rang souhaitée avec les adresses de rang enregistrées dans la colonne de la mémoire de répertoire choisie par une adresse de colonne souhaitée (LSA) et pour générer des signaux HIT;

des moyens (430, 82) pour accéder au mot de donnée correspondant dans la mémoire de données lors d'un appariement réussi;

des moyens de remplacement (80, 82) pour indiquer un endroit d'antémémoire de remplacement, et pour insérer à cet endroit un mot quin'y est pas encore enregistré; et des moyens de détection d'erreur (86, Fig. 3) pour détecter des erreurs de parité dans les adresses de rang lues dans la mémoire de répertoire, et pour invalider partiellement la mémoire antémémoire lorsque se produit une erreur;

caractérisée par le fait que les moyens de remplacement (80) comprennent des moyens de comptage à exécution circulaire et des moyens de bascule de niveau (RD0, RD1) pour enregistrer des informations codées qui désignent, pour chaque colonne, un niveau suivant parmi lesdits niveaux, dans lequel la donnée de remplacement doit être écrite;

par des moyens de commande de mode (86, Fig. 4) qui combinent un signal de validation de coup au but (HEN)

généré par lesdits moyens de détection d'erreur (Fig. 3) avec le signal HIT pour générer un signal HIT validé dans le cas ou il n'y a pas d'erreur, et pour régler des moyens de bascule de niveau inférieur (DL1, DL2) en cas d'erreu lesdits moyens de commande de mode comprenant de plus des premiers moyens logiques (896, 895) commandés par lesdits moyens de bascule de niveau inférieur pour modifier en partie les signaux de sortie (RD1) provenant desdits moyens de bascule de niveau et pour générer un signal d'invalidation de désignation de niveau (RDM); et par des moyens de commande d'écriture (82, Fig. 5) pour recevoir lesdits signaux HIT, pour recevoir un signal indiquant un remplacement nécessaire (RPL), pour recevoir une autre partie des signaux de sortie (RD0) provenant desdits moyens de bascule de niveau, et pour recevoir ledit signal d'invalidation de désignation de niveau, pour générer des signaux de commande de lecture et d'écriture de désignation de niveau (WRS, WRC), par lesquels un ou plusieurs niveaux (subdivisions) de la mémoire antémémoire peuvent être invalidés.

2. Une mémoire antémémoire selon la revendication 1, dans laquelle les moyens de commande d'écriture (Fig. 5) comprennent un premier décodeur (848) couplé audit signal d'invalidation de désignation de niveau (RDM) et à ladite autre partie des signaux de sortie (RD0) provenant desdits moyens de bascule de niveau, pour générer un signal de commande d'écriture (WRS) pour choisir un niveau pour l'écriture de remplacement, et comprennent de plus un second décodeur (851) également couplé audit signal RDM et audit signal RD0 pour générer un signal de commande de lecture ou d'écriture (WRC) pour choisir un niveau pour la lecture ou la ré-écriture d'un mot déjà stocké dans la mémoire antémémoire.

3. Une mémoire antémémoire selon la revendication 2, dans laquelle lesdits moyens de commande d'écriture (Fig. 5) comprennent une pluralité de bascules de sélection d'écriture (WS0, WS1) pour recevoir lesdits signaux HIT et pour délivrer des signaux de désignation de niveau codé à des circuits logiques de désignation de niveau (843, 841, 845) recevant ledit signal RPL,

ledit signal RD0 et ledit signal RDM, et étant connectés auxdits décodeurs (848, 851).

4. Une mémoire antémémoire selon la revendication 1, dans laquelle lesdits moyens de remplacement (80) comprennent un certain nombre de mémoires (800, 802) adressées par ladite adresse de colonne (LSA), et dont chacune enregistre, pour une bascule associée (RD0, RD1), dans lesdits moyens de bascule de niveau, une information de désignation de niveau codé.

5. Une mémoire antémémoire selon l'une quelconque des revendications précédentes, dans laquelle lesdits moyens de commande de mode ne répondent à des erreurs qu'au cours des opérations de lecture.

6. Une mémoire antémémoire selon la revendication 1, comprenant des seconds moyens logiques (887, PE0, PE1) couplés à des moyens de combinaison de logique (881) pour combiner lesdits signaux HIT avec lesdits signaux HEN, pour indiquer quand l'antémémoire a au moins un niveau inactif.

7. Une mémoire antémémoire selon la revendication 6, dans laquelle lesdits moyens decommande de mode (Fig. 4) comprennent une pluralité de bascules de niveau inférieur (DL1, DL2), dont chacune est associée respectivement avec un niveau ou une pluralité de niveaux, et qui, lorsqu'elles sont réglées rendent le ou les niveaux associés non actifs, lesdites bascules de niveau inférieur étant réglées par lesdits seconds moyens logiques.

8. Une mémoire antémémoire selon la revendication 7, comprenant des moyens logiques ET (898) couplés auxdites bascules de niveau inférieur (DL1, DL2) pour indiquer quand l'antémémoire est totalement inactive.

9. Une mémoire antémémoire selon la revendication 7, comprenant deux bascules de niveau inférieur (DL1, DL2), dont chacune désigne la moitié des niveaux de la mémoire antémémoire, l'une desdites bascules étant réglée lorsque se produit une première erreur, et l'autre étant réglée lorsque se produit une seconde erreur, ce qui par là-même arrête le fonctionnement de la mémoire antémémoire.

FIG.1

FIG.3

FIG.2

FIG 4

FIG.5

EP 0 090 638 B1